# EUROPÄISCHE PATENTSCHRIFT

(11) **EP 2 609 633 B1**
(45) Veröffentlichungstag und Bekanntmachung des Hinweises auf die Patenterteilung: **24.05.2017**
(21) Anmeldenummer: 11743520.6
(22) Anmeldetag: 09.08.2011
(51) Int. Cl.: H01L 33/50, H01L 33/44, H01L 33/38

(54) **STRAHLUNGSEMITTIERENDES BAUELEMENT UND VERFAHREN ZUR HERSTELLUNG EINES STRAHLUNGSEMITTIERENDEN BAUELEMENTS**
RADIATION-EMITTING COMPONENT AND METHOD FOR PRODUCING A RADIATION-EMITTING COMPONENT
COMPOSANT ÉMETTEUR DE RAYONNEMENT ET PROCÉDÉ DE FABRICATION D'UN COMPOSANT ÉMETTEUR DE RAYONNEMENT

(30) Priorität: 26.08.2010 DE 102010035490
(43) Veröffentlichungstag der Anmeldung: 03.07.2013
(73) Patentinhaber: OSRAM Opto Semiconductors GmbH, 93055 Regensburg (DE)
(72) Erfinder: PREUß, Stephan, 32832 Augustdorf (DE)
(74) Vertreter: Epping - Hermann - Fischer
(86) Internationale Anmeldenummer: PCT/EP2011/063701
(87) Internationale Veröffentlichungsnummer: WO 2012/025377

(56) Entgegenhaltungen:
- WO-A1-2007/023411
- WO-A1-2009/039801
- WO-A1-2011/009737
- DE-A1- 10 237 010
- DE-A1- 10 261 428
- DE-A1-102005 045 106
- US-A1- 2007 221 867
- US-A1- 2008 079 017
- US-A1- 2008 116 467
- US-A1- 2008 121 911
- US-B1- 6 603 146

## Beschreibung

Strahlungsemittierendes Bauelement und Verfahren zur Herstellung eines strahlungsemittierenden Bauelements Die vorliegende Anmeldung betrifft ein strahlungsemittierendes Bauelement sowie ein Verfahren zur Herstellung eines strahlungsemittierenden Bauelements. Diese Patentanmeldung beansprucht die Priorität der deutschen Patentanmeldung 10 2010 035 490 2.

Zur Erzeugung von Weißlicht mittels Leuchtdioden kann auf einem zur Strahlungserzeugung vorgesehenen Halbleiterchip Konversionsmaterial aufgebracht werden, das die im Halbleiterchip erzeugte Primärstrahlung so konvertiert, dass für das menschliche Auge weiß erscheinendes Mischlicht entsteht. Das Konversionsmaterial kann beispielsweise in Form von vorgefertigten Konversionsplättchen auf dem Halbleiterchip befestigt werden. Patentschriften US2008/0121911 A1 und US2008/0116467 A1 beschreiben solche Anordnungen. Primärstrahlung, die nicht oder nur zu einem geringen Teil konvertiert wird, beispielsweise seitlich an dem Konversionsmaterial vorbei abgestrahlte Primärstrahlung, kann eine unerwünschte Abhängigkeit des Farborts, also der Koordinaten (Cₓ,C_{y}) im CIE-Farbdiagramm, der abgestrahlten Strahlung vom Abstrahlwinkel verursachen.
Eine Aufgabe ist es, ein strahlungsemittierendes Bauelement anzugeben, bei dem die Abhängigkeit des Farborts vom Abstrahlwinkel reduziert ist. Weiterhin soll ein Verfahren angegeben werden, mit dem ein strahlungsemittierendes Bauelement effizient und zuverlässig hergestellt werden kann.

Diese Aufgaben werden durch ein strahlungsemittierendes Bauelement beziehungsweise ein Herstellungsverfahren gemäß den unabhängigen Patentansprüchen gelöst. Ausgestaltungen und Weiterbildungen sind Gegenstand der abhängigen Patentansprüche.

Ein strahlungsemittierendes Bauelement weist gemäß einer Ausführungsform einen Halbleiterchip, der einen Halbleiterkörper mit einem zur Erzeugung einer Primärstrahlung vorgesehenen aktiven Bereich aufweist, auf. Weiterhin umfasst das strahlungsemittierende Bauelement ein Konversionselement, das zur zumindest teilweisen Umwandlung der Primärstrahlung vorgesehen ist. Das Konversionselement ist mittels einer Verbindungsschicht an dem Halbleiterchip befestigt. In der Verbindungsschicht ist ein Strahlungskonversionsstoff ausgebildet.

Der Strahlungskonversionsstoff in der Verbindungsschicht ist dafür vorgesehen, zumindest einen Teil der Primärstrahlung zu absorbieren und in Sekundärstrahlung mit einer von einer Peak-Wellenlänge der Primärstrahlung verschiedenen Peak-Wellenlänge umzuwandeln.

Die Strahlungsumwandlung kann somit nicht nur in dem vorzugsweise vorgefertigten Konversionselement, sondern auch in der Verbindungsschicht erfolgen.

In einer bevorzugten Ausgestaltung überragt die Verbindungsschicht das Konversionselement in einer lateralen Richtung zumindest bereichsweise. Unter einer lateralen Richtung wird in diesem Zusammenhang eine Richtung verstanden, die entlang einer Haupterstreckungsebene des aktiven Bereichs verläuft.
Somit kann die Verbindungsschicht auch Strahlungsanteile umwandeln, die an dem Konversionselement vorbei aus dem strahlungsemittierenden Bauelement austreten würden und zu einer verstärkten Winkelabhängigkeit des Farborts der emittierten Strahlung führen würden.

In der erfindungsgemäßen Ausgestaltung ist in dem Konversionselement ein Fenster ausgebildet. Das Fenster erstreckt sich zweckmäßigerweise in vertikaler Richtung, also in einer senkrecht zur Haupterstreckungsebene des aktiven Bereichs verlaufenden Richtung, vollständig durch das Konversionselement hindurch. Der Halbleiterchip ist durch das Fenster hindurch elektrisch kontaktierbar oder elektrisch kontaktiert.

In der erfindungsgemäßen Ausgestaltung ist das Fenster in Aufsicht auf den Halbleiterchip seitlich des Halbleiterkörpers ausgebildet. Weiterhin bevorzugt ist der Halbleiterkörper auf der dem Konversionselement zugewandten Seite frei von einem elektrischen Kontakt. Mit anderen Worten sind auf einer zur Abstrahlung vorgesehenen Strahlungsdurchtrittsfläche des Halbleiterkörpers keine externen elektrischen Kontakte erforderlich, welche den Strahlungsaustritt aus dem Halbleiterkörper behindern könnten.

In einer alternativen Ausgestaltung, die jedoch nicht zu der Erfindung wie beansprucht gehört, überlappt das Fenster mit dem Halbleiterkörper in Aufsicht. Eine externe elektrische Kontaktierung einer dem Konversionselement zugewandten Halbleiterschicht des Halbleiterkörpers ist so vereinfacht.

In einer bevorzugten Weiterbildung dieser Ausgestaltung überlappt die Verbindungsschicht mit dem Fenster in Aufsicht auf den Halbleiterchip zumindest bereichsweise. Mit anderen Worten ist die Verbindungsschicht zumindest teilweise in Bereichen ausgebildet, in denen der Halbleiterchip nicht von dem Konversionselement bedeckt ist. Somit kann im Bereich des Fensters abgestrahlte Primärstrahlung mittels der Verbindungsschicht zumindest teilweise konvertiert werden. Eine Winkelabhängigkeit des Farborts der abgestrahlten Strahlung kann so weitergehend vermindert werden. Der Halbleiterkörper weist vorzugsweise eine Seitenfläche auf, die den Halbleiterkörper in lateraler Richtung begrenzt. In einer bevorzugten Ausgestaltung bedeckt die Verbindungsschicht die Seitenfläche zumindest bereichsweise. Somit kann auch Strahlung, die seitlich, also in lateraler Richtung, aus dem Halbleiterchip austreten würde und somit an dem Konversionselement vorbei aus dem strahlungsemittierenden Bauelement abgestrahlt würde, zumindest teilweise in Sekundärstrahlung umgewandelt werden. In einer weiteren bevorzugten Ausgestaltung ist die Verbindungsschicht hinsichtlich der Umwandlung der Primärstrahlung an das Konversionselement, insbesondere bezüglich hinsichtlich der Zusammensetzung Konversionsmaterials und/oder der Konzentration des Konversionsmaterials angepasst. Mit anderen Worten ist die Verbindungsschicht vorzugsweise so ausgebildet, dass die Primärstrahlung beim alleinigen Durchtritt durch die Verbindungsschicht zu einem vergleichbar großen Anteil in Sekundärstrahlung umgewandelt wird wie in dem Konversionselement.

Insbesondere kann zumindest ein Konversionsstoff sowohl in dem Konversionselement als auch in der Verbindungsschicht enthalten sein.

In einer bevorzugten Ausgestaltung enthält die Verbindungsschicht ein Polymermaterial. Das Polymermaterial ist zweckmäßigerweise für die im Halbleiterchip erzeugte Primärstrahlung transparent oder zumindest transluzent. Bevorzugt enthält die Verbindungsschicht ein Silikon.

Bei einem Verfahren zur Herstellung eines strahlungsemittierenden Bauelements wird gemäß einer Ausführungsform an einem Halbleiterchip, der einen Halbleiterkörper mit einem zur Erzeugung einer Primärstrahlung vorgesehenen aktiven Bereich aufweist, mittels einer Verbindungsschicht ein Konversionselement befestigt, wobei in der Verbindungsschicht ein Strahlungskonversionsstoff ausgebildet ist.

Bei der Herstellung wird ein Verbindungsmaterial für die Verbindungsschicht vorzugsweise derart aufgebracht, dass es sich beim Anordnen des Konversionselements über eine den Halbleiterchip in lateraler Richtung begrenzende Seitenfläche hinaus erstreckt. Ein Anteil eines Materials für die Verbindungsschicht, das sich in lateraler Richtung über das Konversionselement hinaus erstreckt, ist insbesondere mittels der Menge des aufgebrachten Materials, der Viskosität des Materials und/oder des thixotropen Verhaltens des Materials einstellbar. Insbesondere kann so ein gezieltes Überlaufen des Verbindungsmaterials über die Seitenfläche des Halbleiterkörpers erzielt werden.
In einer Ausgestaltungsvariante wird der Halbleiterchip vor dem Befestigen des Konversionselements elektrisch kontaktiert, beispielsweise mittels einer Drahtbondverbindung. Der Halbleiterchip kann beispielsweise in einem Gehäuse eines oberflächenmontierbaren Bauelements (surface mounted device, smd) oder auf einem Anschlussträger, etwa einer Leiterplatte befestigt werden. Nach der elektrischen Kontaktierung kann das Verbindungsmaterial zumindest bereichsweise an die elektrische Kontaktierung angeformt werden. So ist vereinfacht sichergestellt, dass die aus dem Halbleiterkörper austretende Strahlung die Verbindungsschicht durchläuft und somit zumindest teilweise in Sekundärstrahlung umgewandelt wird.
In einer alternativen Ausgestaltungsvariante wird die Verbindungsschicht derart ausgebildet, dass sie den elektrischen Kontakt nicht oder zumindest nur bereichsweise bedeckt. Im freiliegenden Bereich des Kontakts ist der Halbleiterchip elektrisch kontaktierbar.

In der erfindungsgemäßen Ausgestaltung grenzt die Verbindungsschicht zumindest bereichsweise unmittelbar an den elektrischen Kontakt an. So ist auf einfache Weise gewährleistet, dass seitlich des Kontakts austretende Strahlung zumindest teilweise in Sekundärstrahlung umgewandelt wird.
Das beschriebene Verfahren ist zur Herstellung eines weiter oben beschriebenen strahlungsemittierenden Bauelements besonders geeignet. Im Zusammenhang mit dem Bauelement angeführte Merkmale können daher auch für das Verfahren herangezogen werden und umgekehrt.
Weitere Merkmale, Ausgestaltungen und Zweckmäßigkeiten ergeben sich aus der folgenden Beschreibung der Ausführungsbeispiele in Verbindung mit den Figuren.
Es zeigen:
die Figuren 1A und 1B ein erfindungsgemäßes Ausführungsbeispiel für ein strahlungsemittierendes Bauelement in schematischer Aufsicht (Figur 1A) und zugehöriger Schnittansicht (Figur 1B);
Figur 2 ein Ausführungsbeispiel für ein strahlungsemittierendes Bauelement in schematischer Schnittansicht, der jedoch nicht zu der Erfindung wie beansprucht gehört;
Figur 3 ein Ausführungsbeispiel für ein strahlungsemittierendes Bauelement in schematischer Schnittansicht, der jedoch nicht zu der Erfindung wie beansprucht gehört; und
die Figuren 4A bis 4C ein Ausführungsbeispiel für ein Verfahren zur Herstellung eines strahlungsemittierenden Bauelements der Figur 2 anhand von schematisch in Schnittansicht dargestellten Zwischenschritten.

Gleiche, gleichartige oder gleich wirkende Elemente sind in den Figuren mit denselben Bezugszeichen versehen.
Die Figuren und die Größenverhältnisse der in den Figuren dargestellten Elemente untereinander sind nicht als maßstäblich zu betrachten. Vielmehr können einzelne Elemente zur besseren Darstellbarkeit und/oder zum besseren Verständnis übertrieben groß dargestellt sein.

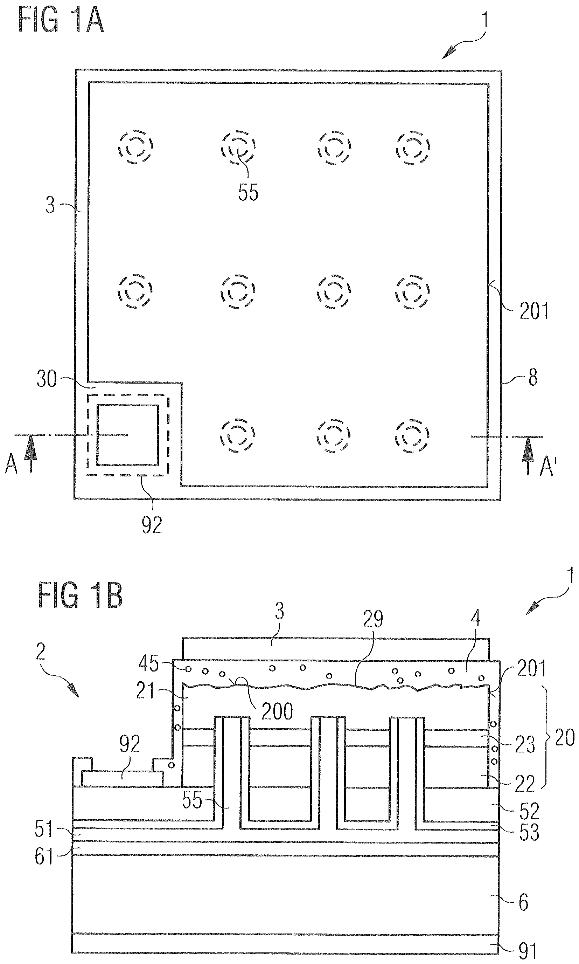

Ein erfindungsgemäßes Ausführungsbeispiel für ein strahlungsemittierendes Bauelement 1 ist in der Figur 1A in schematischer Aufsicht und in der Figur 1B in einer Schnittansicht entlang der Linie AA' gezeigt.
Das strahlungsemittierende Bauelement 1 weist einen Halbleiterchip 2 und ein Konversionselement 3 auf. Das Konversionselement ist mittels einer Verbindungsschicht 4 an dem Halbleiterchip befestigt.
Der Halbleiterchip 2 weist einen Halbleiterkörper 20 mit einer Halbleiterschichtenfolge, die den Halbleiterkörper bildet, auf. Die Halbleiterschichtenfolge umfasst einen zur Erzeugung von Strahlung vorgesehenen aktiven Bereich 23, der zwischen einem ersten Halbleiterbereich 21 und einem zweiten Halbleiterbereich 22 angeordnet ist.
Der Halbleiterkörper 20 ist mittels einer Montageschicht 61 auf einem Träger 6 befestigt. Der Träger 6 dient insbesondere der mechanischen Stabilisierung des Halbleiterkörpers 20. Ein Aufwachssubstrat für die Halbleiterschichtenfolge des Halbleiterkörpers 20 ist hierfür nicht erforderlich und kann deshalb bei der Herstellung vollständig oder zumindest bereichsweise entfernt oder gedünnt werden.

Ein Halbleiterchip, bei dem das Aufwachssubstrat entfernt ist, wird auch als Dünnfilmhalbleiterchip bezeichnet.

Ein Dünnfilm-Halbleiterchip, etwa ein Dünnfilm-Leuchtdioden-Chip, kann sich weiterhin im Rahmen der vorliegenden Erfindung durch mindestens eines der folgenden charakteristischen Merkmale auszeichnen:
- an einer zu einem Trägerelement, beispielsweise dem Träger 6, hin gewandten ersten Hauptfläche eines Halbleiterkörpers, der eine Halbleiterschichtenfolge mit einem aktiven Bereich umfasst, insbesondere einer Epitaxieschichtenfolge, ist eine Spiegelschicht aufgebracht oder, etwa als Braggspiegel in der Halbleiterschichtenfolge integriert, ausgebildet, die zumindest einen Teil der in der Halbleiterschichtenfolge erzeugten Strahlung in diese zurückreflektiert;
- die Halbleiterschichtenfolge weist eine Dicke im Bereich von 20µm oder weniger, insbesondere im Bereich von 10 µm auf; und/oder
- die Halbleiterschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der Halbleiterschichtenfolge führt, d.h. sie weist ein möglichst ergodisch stochastisches Streuverhalten auf.

Ein Grundprinzip eines Dünnfilm-Leuchtdiodenchips ist beispielsweise in I. Schnitzer et al., Appl. Phys. Lett. 63 (16), 18. Oktober 1993, 2174 - 2176 beschrieben, deren Offenbarungsgehalt insofern hiermit durch Rückbezug in die vorliegende Anmeldung aufgenommen wird.

Der Halbleiterkörper weist Ausnehmungen 55 auf, die sich vom Träger 6 durch den zweiten Halbleiterbereich 22 und den aktiven Bereich 23 hindurch in den ersten Halbleiterbereich 21 hinein erstrecken. In den Ausnehmungen 55 ist eine erste Anschlussschicht 71 ausgebildet, die mit dem Halbleiterbereich 21 elektrisch leitend verbunden ist.

Die Seitenflächen der Ausnehmungen 55 sind mit einer Isolationsschicht 53 bedeckt. Die Isolationsschicht dient der elektrischen Isolation der ersten Anschlussschicht 51 vom aktiven Bereich 23 und vom zweiten Halbleiterbereich 22.

Zwischen der ersten Anschlussschicht 51 und dem zweiten Halbleiterbereich 22 ist eine zweite Anschlussschicht 52 ausgebildet. Die zweite Anschlussschicht 52 ist elektrisch leitend mit dem zweiten Halbleiterbereich 22 verbunden.

Die erste Anschlussschicht 51 und die zweite Anschlussschicht 52 sind mit einem ersten Kontakt 91 beziehungsweise einem zweiten Kontakt 92 elektrisch leitend verbunden, so dass durch Anlegen einer externen elektrischen Spannung zwischen den Kontakten 91 und 92 Ladungsträger über die erste Anschlussschicht 51 und den ersten Halbleiterbereich 21 beziehungsweise über die zweite Anschlussschicht 52 und den zweiten Halbleiterbereich 22 von verschiedenen Seiten in den aktiven Bereich 23 injiziert werden und dort unter Emission von Strahlung rekombinieren können.

Eine dem Träger 6 abgewandte Strahlungsaustrittsfläche 200 des Halbleiterkörpers 20 ist frei von einem externen elektrischen Kontakt. Im aktiven Bereich 23 erzeugte Strahlung kann so besonders effizient durch die Strahlungsaustrittsfläche 200 aus dem Halbleiterchip austreten. Zur Steigerung der Auskoppeleffizienz weist die Strahlungsaustrittsfläche 200 eine Strukturierung 29, beispielsweise eine Aufrauung, auf. Die Strukturierung kann regelmäßig oder unregelmäßig ausgebildet sein.

Die Anschlussschichten 51, 52 enthalten vorzugsweise ein Metall oder eine metallische Legierung oder bestehen aus einem Metall oder einer metallischen Legierung. Die zweite Anschlussschicht 52 weist weiterhin bevorzugt für die im aktiven Bereich 23 erzeugte Strahlung eine hohe Reflektivität auf. In Richtung des Trägers 6 abgestrahlte Strahlung kann so effizient in Richtung der Strahlungsaustrittsfläche 200 umgelenkt werden und aus dieser austreten. Im sichtbaren Spektralbereich eignet sich beispielsweise Silber, Aluminium, Rhodium, Chrom oder Palladium. Im infraroten Spektralbereich weist beispielsweise Gold eine hohe Reflektivität auf.

Das Konversionselement 3 ist dafür vorgesehen, im aktiven Bereich 23 erzeugte Primärstrahlung zumindest teilweise in Sekundärstrahlung umzuwandeln. Beispielsweise kann sich durch Überlagerung von blauer Primärstrahlung mit gelber Sekundärstrahlung für das menschliche Auge ein weißer Farbeindruck ergeben. Das Konversionselement 3 kann auch für eine vollständige Konversion der Primärstrahlung vorgesehen sein. Beispielsweise kann im aktiven Bereich 23 Strahlung im ultravioletten Spektralbereich erzeugt und nachfolgend im Konversionselement in rote, grüne und blaue Strahlung konvertiert werden.

Das zur Strahlungskonversion vorgesehene Konversionsmaterial kann in ein Grundmaterial für das Konversionselement 3 eingebettet sein. Das Grundmaterial für das Konversionselement kann beispielsweise eine Keramik, etwa Aluminiumoxid, oder ein Polymermaterial, etwa ein Silikon, ein Epoxid oder eine Mischung aus einem Silikon und einem Epoxid, enthalten oder aus einem solchen Material bestehen.

Im Bereich des zweiten Kontakts 92 weist das Konversionselement 3 ein Fenster 30 auf, durch das der Halbleiterchip 2 extern elektrisch kontaktierbar ist, beispielsweise mittels einer Drahtbondverbindung.

Das Fenster 30 ist in Aufsicht auf den Halbleiterchip seitlich des Halbleiterkörpers 20 angeordnet. Das Konversionselement 3 bedeckt also die Strahlungsaustrittsfläche 200 des Halbleiterkörpers 20 vollständig. Eine in lateraler Richtung über die Strahlungsaustrittsfläche hinweg gleichmäßige spektrale Abstrahlcharakteristik des Bauelements 1 ist so auf einfache Weise realisiert.

In der Verbindungsschicht 4 ist ein Strahlungskonversionsstoff 45 ausgebildet, der dafür vorgesehen ist, die im aktiven Bereich 23 erzeugte Strahlung zumindest teilweise in Sekundärstrahlung zu konvertieren. Insbesondere ist der Strahlungskonversionsstoff dafür vorgesehen, denjenigen Teil der Primärstrahlung zumindest teilweise zu konvertieren, der im Fall einer vollständig transparenten Verbindungsschicht ohne jegliche Strahlungskonversion aus dem strahlungsemittierenden Bauelement 1 austreten würde. Insbesondere bedeckt die Verbindungsschicht 4 die Seitenflächen 201, die den Halbleiterkörper 20 in lateraler Richtung begrenzen. Auf diese Weise ist sichergestellt, dass seitlich aus dem Halbleiterkörper 20 ausgekoppelte Strahlung zumindest teilweise konvertiert wird.

Vorzugsweise ist die Verbindungsschicht derart ausgebildet, dass Strahlung, die an dem Konversionselement 3 vorbei aus dem Bauelement austreten würde, beispielsweise seitlich aus dem Halbleiterkörper 20 austretende Strahlung, von der Verbindungsschicht 4 zu einem Anteil konvertiert wird, der dem Konversionsanteil für durch das Konversionselement 3 hindurchtretende Strahlung entspricht oder zumindest nahekommt. Auf diese Weise kann erzielt werden, dass die insgesamt von dem strahlungsemittierenden Bauelement 1 abgestrahlte Strahlung bezüglich des Farborts besonders homogen ist. Unter einer homogenen Abstrahlung wird in diesem Zusammenhang insbesondere verstanden, dass der Farbort der abgestrahlten Strahlung nur eine vergleichsweise geringe Abhängigkeit vom Abstrahlungswinkel aufweist.

Für eine besonders homogene Abstrahlung sind das Konversionselement 3 und der Strahlungskonversionsstoff 45 der Verbindungsschicht 4 so aneinander angepasst, insbesondere hinsichtlich der Peak-Wellenlänge der Sekundärstrahlung, dass der Farbort für Strahlung, die nur in der Verbindungsschicht 4 konvertiert wird, dem Farbort für Strahlung, die auch das Konversionselement 3 passiert, entspricht oder zumindest nahe kommt.

Weiterhin überragt die Verbindungsschicht 4 in Aufsicht auf den Halbleiterchip 2 das Konversionselement 3 im Bereich des Fensters 30. In dem gezeigten Ausführungsbeispiel überdeckt die Verbindungsschicht 4 bereichsweise den zweiten Kontakt 92. In dem freiliegenden Bereich ist der zweite Kontakt 92 für eine externe elektrische Kontaktierung zugänglich.

Davon abweichend kann die Verbindungsschicht 4 aber auch so ausgebildet sein, dass sie den zweiten Kontakt 92 nicht bedeckt. Vorzugsweise grenzt die Verbindungsschicht 4 in diesem Fall zumindest bereichsweise, besonders bevorzugt entlang des gesamten Umfangs des zweiten Kontakts 92, an den zweiten Kontakt an. Ein unbeabsichtigt hoher Anteil der Primärstrahlung an der insgesamt austretenden Strahlungsleistung im Bereich des Fensters 30 und eine damit einhergehende Inhomogenität des Farborts kann so besonders zuverlässig vermieden werden.

Die Verbindungsschicht 4 enthält vorzugsweise ein strahlungsdurchlässiges Polymermaterial, beispielsweise ein Silikon.

In dem gezeigten Ausführungsbeispiel ist der Träger 6 zweckmäßigerweise elektrisch leitend ausgebildet. Beispielsweise kann der Träger 6 ein dotiertes Halbleitermaterial, beispielsweise Silizium, Germanium oder Galliumarsenid enthalten oder aus einem solchen Material bestehen. Auch ein Metall oder eine metallische Legierung kann für den Träger Anwendung finden. Von dem gezeigten Ausführungsbeispiel abweichend kann der Träger 6 auch als ein elektrisch isolierender Träger, beispielsweise ein Keramikträger, der mit Durchkontaktierungen versehen ist, ausgeführt sein.

Weiterhin kann der erste Kontakt 91 auch auf der dem Träger 6 abgewandten Seite der ersten Anschlussschicht 51 ausgebildet sein. In diesem Fall ist die Injektion von Ladungsträgern in das Bauelement 1 unabhängig von den elektrischen Eigenschaften des Trägers, so dass auch ein völlig elektrisch isolierender Träger, beispielsweise ein Saphir-Träger, Anwendung finden kann.

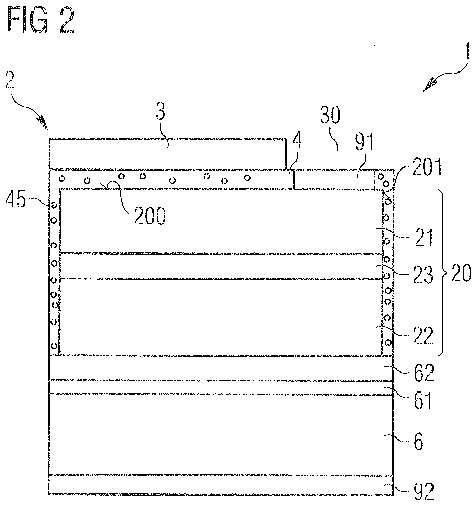

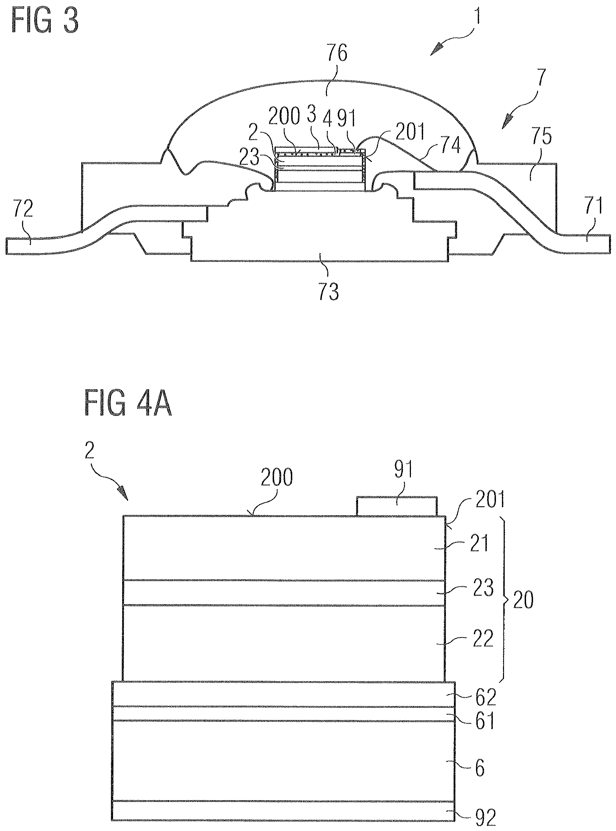

Von dem beschriebenen Ausführungsbeispiel abweichend kann ferner auch ein Halbleiterchip Anwendung finden, bei dem das Aufwachssubstrat nicht entfernt ist, beispielsweise ein in als Flip-Chip ausgeführter Halbleiterchip mit einem Saphir-Aufwachssubstrat als Träger.
Ein Ausführungsbeispiel für ein strahlungsemittierendes Bauelement, das jedoch nicht zu der Erfindung wie beansprucht gehört, ist in Figur 2 in schematischer Schnittansicht dargestellt. Dieses Ausführungsbeispiel entspricht im Wesentlichen dem im Zusammenhang mit Figur 1 beschriebenen ersten Ausführungsbeispiel.
Im Unterschied hierzu ist der erste Kontakt 91 zur elektrischen Kontaktierung des ersten Halbleiterbereichs 21 auf der Strahlungsaustrittsfläche 200 des Halbleiterkörpers 20 ausgebildet. Zur elektrischen Kontaktierung des ersten Halbleiterbereichs sind somit keine Ausnehmungen durch den aktiven Bereich 23 erforderlich.
Das Fenster 30 im Konversionselement 3 ist wie im ersten Ausführungsbeispiel so angeordnet, dass der erste Kontakt 91 für eine externe elektrische Kontaktierung freiliegt. Zwischen dem Träger 6 und dem Halbleiterkörper 20 ist eine Spiegelschicht 62 angeordnet, die dafür vorgesehen ist, im aktiven Bereich 23 erzeugte und in Richtung des Trägers 6 abgestrahlte Strahlung umzulenken. Für die Spiegelschicht 62 eignet sich insbesondere eines der im Zusammenhang mit der zweiten Anschlussschicht 72 genannten Materialien.
Wie im Zusammenhang mit Figur 1 beschrieben, kann die Strahlungsaustrittsfläche 200 eine Strukturierung aufweisen (nicht explizit gezeigt). Eine Grenzfläche zwischen dem ersten Halbleiterbereich 21 und dem ersten Kontakt 91 ist vorzugsweise von der Strukturierung ausgenommen. So kann die Reflektivität des ersten Kontakts 91 für im aktiven Bereich 23 erzeugte Strahlung erhöht und damit der Anteil der am ersten Kontakt absorbierten Strahlung verringert werden.
Ein drittes Ausführungsbeispiel für ein
strahlungsemittierendes Bauelement 1 ist in Figur 3 in schematischer Schnittansicht gezeigt. Der Halbleiterchip 2 und das Konversionselement 3 können wie im Zusammenhang mit den Figuren 1 und 2 beschrieben ausgeführt sein.

Der Halbleiterchip ist in diesem Ausführungsbeispiel in einem vorgefertigten Gehäuse 7 für ein oberflächenmontierbares Bauelement befestigt. Das Gehäuse 7 weist einen Leiterrahmen mit einem ersten Anschlussleiter 71 und einem zweiten Anschlussleiter 72 auf. Die Anschlussleiter ragen aus gegenüberliegenden Seiten aus einem Gehäusekörper 75, beispielsweise einem an den Leiterrahmen angeformten Kunststoffkörper, hinaus. Das Gehäuse 7 weist weiterhin einen thermischen Anschluss 73 auf, auf dem der Halbleiterchip 2 befestigt ist. Im Unterschied zum ersten Anschlussleiter 71 und zum zweiten Anschlussleiter 72 ist dieser vorwiegend nicht für die elektrische Kontaktierung, sondern für eine effiziente Abfuhr der im Betrieb erzeugten Abwärme aus dem Halbleiterchip 2 vorgesehen.

Der erste Kontakt 91 des Halbleiterchips 2 ist über eine Verbindungsleitung 74, etwa eine Bonddrahtverbindung, mit dem ersten Anschlussleiter 71 elektrisch leitend verbunden.

Die Verbindungsschicht 4 ist an die Verbindungsleitung 74 angeformt und bedeckt den von der Verbindungsleitung 74 nicht bedeckten Teil des ersten Kontakts 91. In diesem Ausführungsbeispiel ist die Verbindungsschicht also erst aufgebracht, nachdem der Halbleiterchip 2 bereits mittels der Verbindungsleitung 74 elektrisch kontaktiert ist.

Der Halbleiterchip 2 und die Verbindungsleitung 74 sind in eine Umhüllung 76 eingebettet, die den Halbleiterchip vor äußeren Einflüssen, beispielsweise Feuchtigkeit oder mechanischer Belastung schützt. Für die Umhüllung eignet sich insbesondere ein transparentes oder zumindest transluzentes Polymermaterial, beispielsweise ein Epoxid, ein Silikon oder eine Mischung aus einem Epoxid und einem Silikon.

Ein Ausführungsbeispiel für ein Verfahren zur Herstellung eines strahlungsemittierenden Bauelements 1 ist anhand von Zwischenschritten in schematischer Schnittansicht in den Figuren 4A bis 4C dargestellt. Das Verfahren wird anhand eines strahlungsemittierenden Bauelements beschrieben, das wie im Zusammenhang mit Figur 2 beschrieben ausgeführt ist. Selbstverständlich kann aber auch ein gemäß dem ersten Ausführungsbeispiel ausgeführter Halbleiterchip 1 Anwendung finden.

Wie in Figur 4A dargestellt, wird ein Halbleiterchip 2 mit einem Halbleiterkörper 20 bereitgestellt.

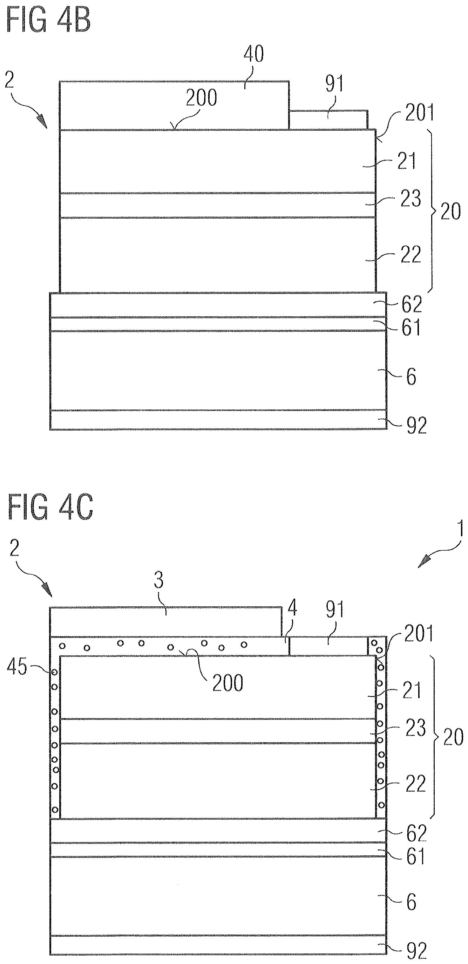

Auf dem Halbleiterkörper 20 wird ein Verbindungsmaterial 40 aufgebracht, in das ein Strahlungskonversionsstoff 45 eingebettet ist. Das Aufbringen kann beispielsweise mittels eines Dispensers erfolgen (Figur 4B). Nachfolgend wird ein vorgefertigtes, beispielsweise mittels Siebdruckens hergestelltes, Konversionselement 3 relativ zum Halbleiterkörper 20 positioniert. Das Konversionselement 3 wird auf das Verbindungsmaterial 40 aufgesetzt. Vorzugsweise ist das Verbindungsmaterial, insbesondere hinsichtlich Thixotropie, Viskosität und aufgebrachter Menge, derart ausgebildet, dass das Verbindungsmaterial beim Aufbringen des Konversionselements 3 über die Seitenflächen 201 des Halbleiterkörpers verläuft und diese bedeckt. Die Befestigung des Konversionselements 3 erfolgt also so, dass sich das Verbindungsmaterial 40 für die Verbindungsschicht 4 in Aufsicht auf den Halbleiterchip über das Konversionselement hinaus erstreckt und Bereiche des Halbleiterchips 2, insbesondere des Halbleiterkörpers 20, bedeckt, die ansonsten unbedeckt wären.

Material, das den ersten Kontakt 91 bedeckt, kann nachfolgend vollständig oder zumindest bereichsweise entfernt werden, so dass der erste Kontakt für eine externe elektrische Kontaktierung freiliegt. Dies kann beispielsweise mittels kohärenter Strahlung oder chemisch, etwa mittels nasschemischen oder trockenchemischen Ätzens erfolgen.

Ein fertig gestelltes Bauelement ist in Figur 4C gezeigt.

Von dem beschriebenen Ausführungsbeispiel abweichend kann das Verbindungsmaterial auch auf dem Konversionselement 3 ausgebildet werden, so dass das Konversionselement 3 zusammen mit dem Verbindungsmaterial 40 auf den Halbleiterchip 2 aufgebracht wird.

Weiterhin kann das Verbindungsmaterial 40 wie im Zusammenhang mit Figur 3 beschrieben auch erst aufgebracht werden, nachdem der Halbleiterchip 2 bereits befestigt ist und elektrisch kontaktiert ist, beispielsweise in einem Gehäuse für das Bauelement oder auf einem Anschlussträger, etwa einer Leiterplatte, beispielsweise einer gedruckten Leiterplatte (printed circuit board, PCB). In diesem Fall wird das Verbindungsmaterial also erst nach der Herstellung einer elektrischen Kontaktierung mit dem ersten Kontakt aufgebracht, so dass auf den ersten Kontakt verlaufendes Material auf dem ersten Kontakt 91 verbleiben kann.
Mit dem beschriebenen Verfahren kann auf einfache Weise ein strahlungsemittierendes Bauelement hergestellt werden, das einen über den Abstrahlwinkel homogenen Farbort aufweist. Die Gefahr von Inhomogenitäten des Farborts aufgrund einer seitlich am Konversionselement abgestrahlten Primärstrahlung kann auf einfache und zuverlässige Weise weitestgehend vermindert werden.
Die Erfindung ist nicht durch die Beschreibung anhand der Ausführungsbeispiele beschränkt. Vielmehr umfasst die Erfindung jede Kombination von Merkmalen wie in den Patentansprüchen beschrieben.

## Patentansprüche

1. Strahlungsemittierendes Bauelement (1) mit einem Halbleiterchip (2), der einen Halbleiterkörper (20) mit einem zur Erzeugung einer Primärstrahlung vorgesehenen aktiven Bereich (23) aufweist, und mit einem Konversionselement (3),
das zur zumindest teilweisen Umwandlung der Primärstrahlung vorgesehen ist, wobei
- das Konversionselement (3) ein vorgefertigtes Konversionselement ist, das mittels einer Verbindungsschicht (4) an dem Halbleiterchip (2) befestigt ist;
- in der Verbindungsschicht (4) ein Strahlungskonversionsstoff (45) ausgebildet ist;
- in dem Konversionselement ein Fenster (30) ausgebildet ist, durch das ein Kontakt (91, 92) des Halbleiterchips (2) elektrisch kontaktierbar oder elektrisch kontaktiert ist; und
- die Verbindungsschicht (4) zumindest bereichsweise an den Kontakt angrenzt, **dadurch gekennzeichnet dass** das Fenster in Aufsicht auf den Halbleiterchip seitlich des Halbleiterkörpers ausgebildet ist.

2. Strahlungsemittierendes Bauelement nach Anspruch 1,
bei dem die Verbindungsschicht das Konversionselement in einer lateralen Richtung zumindest bereichsweise überragt.

3. Strahlungsemittierendes Bauelement nach Anspruch 1 oder 2,
bei dem der Halbleiterkörper auf der dem Konversionselement zugewandten Seite frei von einem elektrischen Kontakt ist.

4. Strahlungsemittierendes Bauelement nach einem der Ansprüche 1 bis 3,
bei dem die Verbindungsschicht in Aufsicht auf den Halbleiterchip zumindest bereichsweise mit dem Fenster überlappt.

5. Strahlungsemittierendes Bauelement nach einem der Ansprüche 1 bis 4,
bei dem die Verbindungsschicht eine den Halbleiterkörper in lateraler Richtung begrenzende Seitenfläche (201) zumindest bereichsweise bedeckt.

6. Strahlungsemittierendes Bauelement nach einem der Ansprüche 1 bis 5,
bei dem die Verbindungsschicht ein Polymermaterial enthält.

7. Strahlungsemittierendes Bauelement nach einem der Ansprüche 1 bis 6,
bei dem die Verbindungsschicht und das Konversionselement hinsichtlich der Zusammensetzung und/oder der Konzentration des Konversionsmaterials so ausgebildet sind, dass der Farbort für Strahlung, die nur in der Verbindungsschicht konvertiert wird, dem Farbort für Strahlung, die auch das Konversionselement passiert, entspricht.

8. Strahlungsemittierendes Bauelement nach einem der Ansprüche 1 bis 7,
bei dem zumindest ein Konversionsstoff sowohl in dem Konversionselement als auch in der Verbindungsschicht enthalten ist.

9. Verfahren zur Herstellung eines strahlungsemittierenden Bauelements (1) bei dem an einem Halbleiterchip, der einen Halbleiterkörper (20) mit einem zur Erzeugung einer Primärstrahlung vorgesehenen aktiven Bereich (23) aufweist, mittels einer Verbindungsschicht (4) ein Konversionselement (3), in dem ein Fenster (30) ausgebildet ist, durch das ein Kontakt (91, 92) des Halbleiterchips (2) elektrisch kontaktierbar ist, befestigt wird, wobei in der Verbindungsschicht (4) ein Strahlungskonversionsstoff (5) ausgebildet ist und die Verbindungsschicht (4) zumindest bereichsweise an den Kontakt angrenzt, **dadurch gekennzeichnet dass** das Fenster in Aufsicht auf den Halbleiterchip seitlich des Halbleiterkörpers ausgebildet ist.

10. Verfahren nach Anspruch 9,
bei dem die Verbindungsschicht (4) mittels eines Dispensers aufgebracht wird.

11. Verfahren nach Anspruch 9 oder 10,
bei dem ein Material für die Verbindungsschicht (4) derart aufgebracht wird, dass es sich beim Anordnen des Konversionselements über eine den Halbleiterkörper in lateraler Richtung begrenzende Seitenfläche (201) hinaus erstreckt.

12. Verfahren nach einem der Ansprüche 9 bis 11,
bei dem der Halbleiterchip auf der dem Konversionselement zugewandten Seite vor dem Befestigen des Konversionselements elektrisch kontaktiert wird.

## Claims

1. A radiation-emitting component (1) comprising a semiconductor chip (2), which has a semiconductor body (20) having an active region (23) provided for generating a primary radiation, and comprising a conversion element (3), which is provided for at least partly converting the primary radiation, wherein
- the conversion element (3) is a prefabricated radiation conversion element that is fixed to the semiconductor chip (2) by means of a connecting layer (4) ;
- a radiation conversion substance (45) is formed in the connecting layer (4);
- a window (30) is formed in the conversion element, through which window electrical contact can be made or electrical contact is made with the semiconductor chip; and
- the connecting layer (4) adjoins the contact at least in regions,
**characterized in that**
the window is formed laterally with respect to the semiconductor body in a plan view of the semiconductor chip.

2. The radiation-emitting component according to claim 1,
wherein the connecting layer projects beyond the conversion element in a lateral direction at least in regions.

3. The radiation-emitting component according to claim 1 or 2,
wherein the semiconductor body is free from an electrical contact on a side facing the conversion element.

4. The radiation-emitting component according to any of claims 1 to 3,
wherein the connecting layer overlaps the window at least in regions in a plan view of the semiconductor chip.

5. The radiation-emitting component according to any of claims 1 to 4,
wherein the connecting layer covers at least in regions a side area (201) delimiting the semiconductor body in a lateral direction.

6. The radiation-emitting component according to any of claims 1 to 5,
wherein the connecting layer contains a polymer material.

7. The radiation-emitting component according to any of claims 1 to 6,
wherein the connecting layer and the conversion element are formed with respect to the composition and/or the conzentration of the conversion material in such a way that the color locus for radiation which is converted only in the connecting layer corresponds to the color locus for radiation which also passes through the conversion element.

8. The radiation-emitting component according to any of claims 1 to 7,
whereinat least one conversion substance is contained both in the conversion element and in the connecting layer.

9. A method for producing a radiation-emitting component (1),
wherein, by means of a connecting layer (4), a conversion element (3), in which a window (30) is formed through which a contact (91, 92) of the semiconductor chip (2) is electrically contactable, is fixed to a semiconductor chip having a semiconductor body (20) having an active region (23) provided for generating a primary radiation, wherein a radiation conversion substance (5) is formed in the connecting layer (4) and the connecting layer (4) adjoins the contact at least in regions,
**characterized in that**
the window is formed laterally with respect to the semiconductor body in a plan view of the semiconductor chip.

10. The method according to claim 9,
wherein the connecting layer (4) is applied by means of a dispenser.

11. The method according to claim 9 or 10,
wherein a material for the connecting layer (4) is applied in such a way that, upon the arrangement of the conversion element, said material extends beyond a side area (201) delimiting the semiconductor body in a lateral direction.

12. The method according to any of claims 9 to 11,
wherein electrical contact is made with the semiconductor chip on the side facing the conversion element before the conversion element is fixed.

## Revendications

1. Composant (1) émettant un rayonnement, comprenant une puce à semi-conducteur (2) qui présente un corps semi-conducteur (20) muni d'une zone active (23) ménagée pour générer un rayonnement primaire, et comprenant un élément de conversion (3) qui est ménagé pour la conversion au moins partielle du rayonnement primaire,
- l'élément de conversion (3) étant un élément de conversion préfabriqué qui est fixé sur la puce à semi-conducteur (2) au moyen d'une couche de liaison (4) ;
- une substance de conversion de rayonnement (45) étant réalisée dans la couche de liaison (4) ;
- une fenêtre (30) étant réalisée dans l'élément de conversion, au moyen de laquelle un contact (91, 92) de la puce à semi-conducteur (2) peut être mis en contact électrique ou est mis en contact électrique ;
et
- la couche de liaison (4) étant adjacente au contact au moins par endroits, **caractérisé en ce que** la fenêtre, en vue de dessus sur la puce à semi-conducteur, est réalisée latéralement du corps semi-conducteur.

2. Composant émettant un rayonnement selon la revendication 1, dans lequel la couche de liaison dépasse l'élément de conversion au moins en partie dans une direction latérale.

3. Composant émettant un rayonnement selon la revendication 1 ou 2, dans lequel le corps semi-conducteur, sur le côté tourné vers l'élément de conversion, est exempt d'un contact électrique.

4. Composant émettant un rayonnement selon l'une quelconque des revendications 1 à 3,
dans lequel la couche de liaison, en vue de dessus sur la puce à semi-conducteur, chevauche la fenêtre au moins par endroits.

5. Composant émettant un rayonnement selon l'une quelconque des revendications 1 à 4,
dans lequel la couche de liaison recouvre au moins par endroits une surface latérale (201) délimitant le corps semi-conducteur en direction latérale.

6. Composant émettant un rayonnement selon l'une quelconque des revendications 1 à 5,
dans lequel la couche de liaison contient une matière polymère.

7. Composant émettant un rayonnement selon l'une quelconque des revendications 1 à 6,
dans lequel la couche de liaison et l'élément de conversion, au regard de la composition et/ou de la concentration de la matière de conversion, sont réalisés de manière à ce que le lieu de la couleur pour le rayonnement, qui est converti seulement dans la couche de liaison, corresponde au lieu de la couleur pour le rayonnement qui traverse aussi l'élément de conversion.

8. Composant émettant un rayonnement selon l'une quelconque des revendications 1 à 7,
dans lequel au moins une substance de conversion est contenue aussi bien dans l'élément de conversion que dans la couche de liaison.

9. Procédé de fabrication d'un composant (1) émettant un rayonnement, dans lequel procédé, sur une puce à semi-conducteur qui présente un corps semi-conducteur (20) muni d'une zone active (23) ménagée pour générer un rayonnement primaire, est fixé, au moyen d'une couche de liaison (4), un élément de conversion (3), dans lequel est réalisée une fenêtre (30) au moyen de laquelle un contact (91, 92) de la puce à semi-conducteur (2) peut être mis en contact électrique, une substance de conversion de rayonnement (5) étant réalisée dans la couche de liaison (4) et la couche de liaison (4) étant adjacente au contact au moins par endroits, **caractérisé en ce que** la fenêtre, en vue de dessus sur la puce à semi-conducteur, est réalisée latéralement du corps semi-conducteur.

10. Procédé selon la revendication 9,
dans lequel la couche de liaison (4) est appliquée au moyen d'un dispersant.

11. Procédé selon la revendication 9 ou 10,
dans lequel une matière pour la couche de liaison (4) est appliquée de manière à ce que, lors de la disposition de l'élément de conversion, elle s'étende au-delà d'une surface latérale (201) délimitant le corps semi-conducteur en direction latérale.

12. Procédé selon l'une quelconque des revendications 9 à 11,
dans lequel la puce à semi-conducteur, sur le côté tourné vers l'élément de conversion, est mise en contact électrique avant la fixation de l'élément de conversion.
